# EUROPÄISCHE PATENTSCHRIFT

(11) **EP 0 970 774 B1**
(45) Veröffentlichungstag und Bekanntmachung des Hinweises auf die Patenterteilung: **24.07.2002**
(21) Anmeldenummer: 99113056.8
(22) Anmeldetag: 21.06.1996
(51) Int. Cl.: B23K 3/06, H01L 23/12

(54) **Formstempel zum Austragen von flüssigem Lot**
Molding die for dispensing liquid solder
Matrice de moulage pour appliquer du plomb liquide

(30) Priorität: 01.07.1995 CH 192695
(43) Veröffentlichungstag der Anmeldung: 12.01.2000
(62) Teilanmeldung aus: 96110030.2
(73) Patentinhaber: ESEC Trading SA, 6330 Cham (CH)
(72) Erfinder: Lüchinger, Christoph, 6330 Cham (CH); Suter, Guido, 6312 Steinhausen (DE)
(74) Vertreter: Falk, Urs, Dr.

(56) Entgegenhaltungen:
- DE-A- 4 136 723
- JP-A- 1 249 163
- US-A- 2 875 719
- US-A- 3 804 566
- US-A- 4 527 717
- US-A- 4 577 398
- US-A- 4 709 849
- US-A- 5 364 011

## Beschreibung

Die Erfindung betrifft einen auswechselbaren Formstempel zum Austragen von flüssigem Lot gemäss dem Oberbegriff des Anspruches 1. Ein derartiger Formstempel ist aus der US-A-1 561 924 bekannt.

Bei der Montage von Halbleiter-Elementen (Chips) auf einem metallischen Träger (lead frame) werden typischerweise - jedoch nicht ausschliesslich - Lötverfahren angewendet. Hauptsächlich Leistungshalbleiter werden in der Regel mit dem Substrat (üblicherweise Kupfer) mittels Weichlötung verbunden, um über die Lötverbindung eine (im Vergleich zur Montage mittels Klebstoff) wirksame Ableitung der beim Betrieb entstehenden Verlustwärme aus dem Halbleiter-Chip zu gewährleisten. Allerdings werden, vor allem bei gesteigerter Leistungsdichte, hohe Anforderungen an die Homogenität der Lötverbindung gestellt, d.h. es werden definierte Dicke, gleichmässige Verteilung und einwandfreie Benetzung der Lotschicht über die ganze Chipfläche, bzw. völlige Blasenfreiheit sowie Reinheit der Lötstelle verlangt; andererseits soll aber das Lot möglichst nicht aus dem Lotspalt seitlich austreten und sich neben dem Chip ausbreiten, was wiederum eine genaue Dosierung und Positionierung der Lotportionen erfordert.

Es sind im Anwendungsbereich der Chip-Montage hauptsächlich zwei Lötverfahren bekannt und im praktischen Einsatz. Im einen Fall wird das Ende eines Lötmetall-Drahtes mit dem über die Schmelztemperatur des Lotes erhitzten Substrat in Berührung gebracht, um ein Stück des Drahtes abzuschmelzen. Dieses Verfahren ist aufgrund seiner Einfachheit und Flexibilität für die Massenproduktion an sich gut geeignet. Jedoch hängt der Schmelzvorgang, vor allem das Volumen und die Positionierung der Lotportion, sehr stark von der Materialpaarung und den Oberflächeneigenschaften des Substrats ab, d.h. die Menge und Position des jeweils abschmelzenden Lotes sind erheblichen Streuungen unterworfen. Zudem ist die entstehende, etwa kreisförmige Benetzungsfläche schlecht an die rechteckige oder quadratische Gestalt der Chips angepasst.

Das zweite bekannte Verfahren besteht darin, dass flache Formlinge aus Lötmetall, deren Abmessungen auf die Chips abgestimmt sind, vorfabriziert werden (sogen. "solder preform"); die Formlinge werden dann auf das Substrat aufgelegt und von diesem aufgeschmolzen, um eine Lotschicht in den verlangten Dimensionen zu bilden (US-A 4,577,398 und US-A 4,709,849). Wegen der erforderlichen Vorfabrikation der Lot-Formlinge und den zusätzlichen Montageoperationen ist diese Methode allerdings recht kostspielig und wenig flexibel. Bei beiden vorerwähnten Verfahren muss übrigens die Schmelzwärme dem Lot über das Substrat zugeführt werden, was eine entsprechende Überhitzung desselben erfordert und eine gewisse Zeit in Anspruch nimmt, wobei die Wahl der Substrat-Temperatur eingeschränkt ist.

Aus der Patentschrift US 1,561,924 ist ein Formstempel mit einem Formhohlraum zum Formen von metallischen Barren bekannt. Aus der Patentschrift US 3,804,566 ist ein Stempel bekannt, der beim Kunststoffspritzgiessen verwendet wird. Der Stempel weist Entlüftungskanäle auf, die gegen den Hohlraum des Stempels hin abgedichtet sind, damit nur Luft, aber kein Kunststoff durch die Entlüftungskanäle entweichen kann.

Ausgehend von diesem Stand der Technik sollen mit der vorliegenden Erfindung die vorerwähnten Nachteile bekannter Anordnungen überwunden werden. Insbesondere ist es eine Aufgabe der Erfindung, eine speziell für die Anwendung bei der Chipmontage taugliche Einrichtung zum portionenweisen Austragen von flüssigem Weichlot vorzuschlagen, mit dem das Dosieren der Lotportionen über einen grossen Gewichts- bzw. Volumenbereich mit hoher Genauigkeit und Zuverlässigkeit möglich ist.

Diese Aufgabe wird erfindungsgemäss mit einem Formstempel nach Patentanspruch 1 gelöst.

Die Verwendung eines Formstempels beim Auftragen der Lotportionen auf ein Substrat ermöglicht es, Portionen mit definierter Flächenausdehnung und Dicke zu erzeugen.

Nachstehend wird ein Ausführungsbeispiel der Erfindung im Zusammenhang mit der Zeichnung näher erläutert, wobei die Anwendung bei der Montage von Halbleiter-Chips auf einem metallischen Substrat im Vordergrund steht.
- Fig. 1: zeigt im Vertikalschnitt und teilweise schematisch eine Einrichtung mit einem Formstempel zum Weichlöten von Halbleiter-Chips auf einem metallischen Substrat,
- Fig. 2: ist ein Horizontalschnitt auf der Höhe der Linie II-II in Fig. 1,
- Fig. 3: zeigt die Ansicht von unten des bei der Einrichtung nach Fig. 1 verwendeten Formstempels,
- Fig. 4: ist die teilweise geschnittene Seitenansicht und
- Fig. 5: die Draufsicht des gleichen Formstempels,
- Fig. 6: zeigt im Schnitt den auf dem Substrat aufliegenden Formstempel mit in den Formhohlraum ausgestossener Lotportion, und
- Fig. 7: zeigt im grösseren Massstab eine besondere Ausführung der verengten Austrittsmündung.

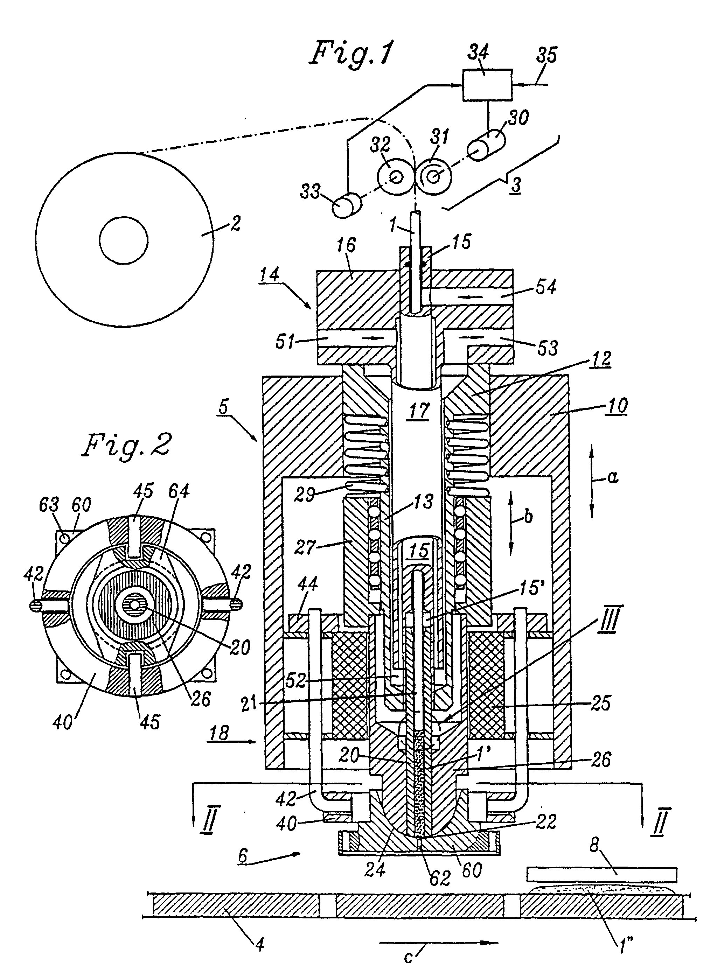

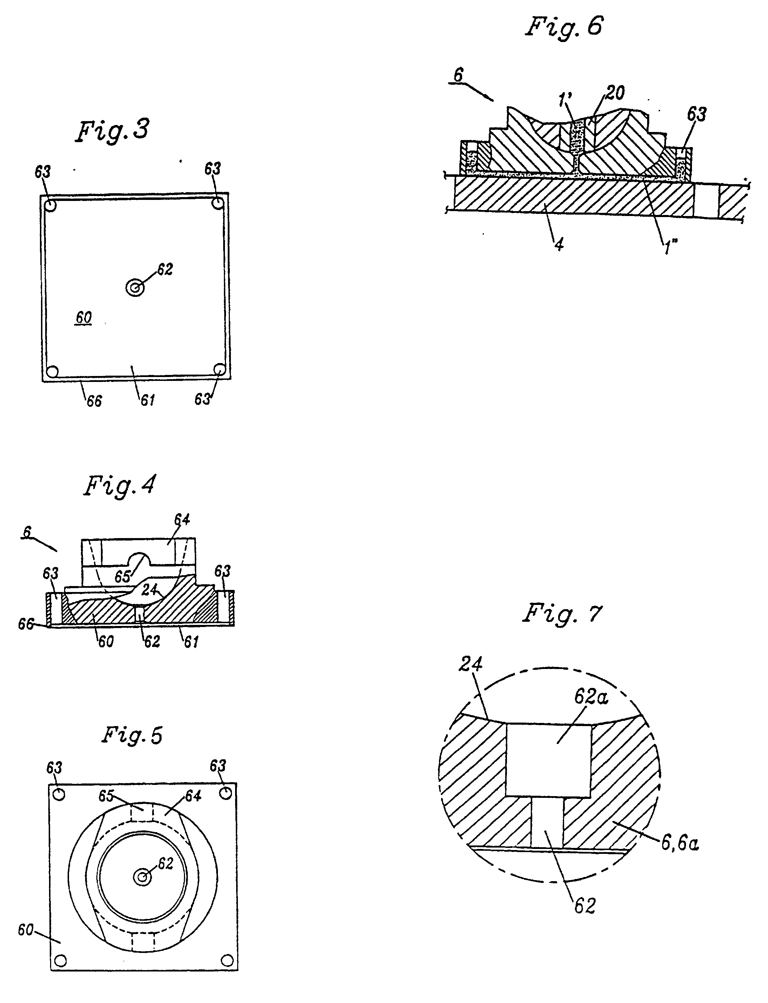

Die in Fig. 1 als Ganzes dargestellte, beispielhafte Anordnung dient dazu, auf ein metallisches, streifenförmiges Substrat 4 (lead frame), das in Richtung des Pfeiles c schrittweise weitertransportiert wird, Halbleiter-Chips 8 mittels Weichlot aufzulöten. Ein Lötmetall-Draht 1 (Durchmesser z.B. 1 mm oder 0,76 mm) wird von einer Spule 2 abgezogen, mit Hilfe von Antriebsmitteln 3 von oben nach unten durch eine Einrichtung 5 längsgeführt vorgeschoben und in deren unterem Bereich aufgeschmolzen. Die Einrichtung 5 ist als Ganzes heb- und senkbar (Pfeil a). Der Austrag von flüssigem Lot 1' erfolgt in einzelnen Portionen durch schrittweise Betätigung des Antriebs 3, beim vorliegenden Beispiel über einen Formstempel 6 jeweils bei abgesenkter, mit dem Formstempel auf dem Substrat 4 aufliegender Einrichtung 5 (siehe Fig. 6). Das beheizte, metallische Substrat 4 wird dabei vom Lot benetzt. Die Einrichtung 5 wird hierauf angehoben und das Substrat 4 mit der übernommenen Lotportion 1" weitertransportiert, worauf, wie nur schematisch angedeutet, ein Chip 8 auf die noch flüssige Lotportion 1" plaziert wird.

Die etwa vertikal stehende Einrichtung 5 besteht im wesentlichen aus einem rohrförmigen Gehäuse 10, einem Führungsteil 12, einem Anschlussteil 14, einer Schmelzeinheit 18 mit Formstempel 6, sowie dem Antrieb 3. Der Führungsteil 12 und der Anschlussteil 14 sind im Gehäuse 10 fest eingebaut. Die Schmelzeinheit 18 zusammen mit dem Formstempel 6 kann dagegen entlang dem Führungsteil 12 einen gewissen Vertikalhub ausführen (Pfeil b).

Der Führungsteil 12 weist ein nach unten ragendes Rohr 13 auf. Innerhalb des Rohres 13 befinden sich zwei weitere, konzentrische Rohre 15 und 17, die vom Kopf 16 des Anschlussteils 14 ausgehen. Die unteren Enden der Rohre 15 und 13 sind aneinander zentriert. Durch die Längsbohrung des inneren Rohres 15 erstreckt sich das feste Lot 1. Ein unterer Abschnitt 15' dieser Längsbohrung ist erweitert, um ein Führungsrohr 20, welches zur Schmelzeinheit 18 gehört, gleitend aufzunehmen. Die Längsbohrung 21 des Führungsrohres 20 reicht bis zum Austrittsende 22 und ist dem Durchmesser des festen, draht- oder stangenförmigen Weichlots 1 angepasst (höchstens etwa 5-10 % Übermass).

Die Schmelzeinheit 18 ist von einer im Innern des Gehäuses 10 fest montierten, ringförmigen, elektrischen Heizung 25 umgeben. Sie erhitzt berührungslos einen zylindrischen Tiegel 26, dessen oberes Ende von einer Hülse 27 gehalten ist. Die letztere ist über eine Kugelführung am Rohr 13 verschiebbar geführt. Tiegel 26 und Führungsrohr 20 sind an ihren unteren Enden miteinander fest verbunden.

Von der Heizung 25 wird der Tiegel 26 und von diesem ein unterer Bereich des vertikalen Führungsrohres 20 einschliesslich des unteren Rohrendes 22 zum Aufschmelzen des Lots aufgeheizt, so dass sich in der Bohrung 21 unten im Rohr 20 schmelzflüssiges Lot 1' befindet.

Die Temperatur im aufgeheizten, unteren Bereich des Rohres 20 wird im allgemeinen höher sein als die Liquidustemperatur des Lotmaterials, so dass das Lot dann vollständig geschmolzen wird; es können jedoch gewisse Lotlegierungen auch bei Temperaturen unterhalb Liquidustemperatur verarbeitet werden, bei denen das Lotmaterial nur teilweise schmelzflüssig ist (Fest/Flüssig-Gemisch). Dieser letztere Fall soll demnach immer mit eingeschlossen sein, auch wenn im folgenden einfach von "schmelzflüssig" oder "Schmelze" die Rede ist. Wie noch näher ausgeführt wird, kann jeweils durch Betätigung des Antriebs 3 bzw. Vorschub des festen Lots 1 im Führungsrohr 20 eine Portion von flüssigem Lot 1' unten aus der Bohrung 21 ausgestossen werden. Der Ausstoss erfolgt im vorliegenden Fall in den Formstempel 6 über dessen Eingusskanal 62, der eine an die Bohrung 21 anschliessende, verengte Austrittsmündung bildet.

Ein oberer, an den beheizten Bereich anschliessender Bereich des Rohres 20 wird intensiv auf eine Temperatur deutlich unterhalb der Solidustemperatur des Lotmaterials gekühlt. Zu diesem Zweck enthält der Anschlussteil 14 eine Anordnung zur Zirkulation eines geeigneten Kühlmediums, z.B. Pressluft. Das Kühlmedium wird durch einen Kanal 51 zugeführt, strömt dann in der Bohrung des Rohres 17 aussen am Rohr 15 entlang nach unten bis zu einem Ringkanal 52 und von dort aussen am Rohr 17 entlang wieder nach oben zum Austrittskanal 53. Dabei wird über den dünnwandigen unteren Abschnitt des Rohres 15 das Führungsrohr 20 im oberen Bereich y gekühlt, vorzugsweise mit konstant geregelter Kühlleistung.

Der Temperaturübergang durch das Zusammenwirken von (geregelter) Heizung und Kühlung erweist sich im Betrieb als sehr lagestabil. Der Füllstand der Schmelze in der Bohrung 21 und damit die Schmelzemenge, die jeweils vor dem Ausstossen bereitsteht, werden auf diese Weise kontrolliert. Die verengte Austrittsmündung 62 ermöglicht dabei das Halten der Schmelze, auch wenn dafür die Kapillarwirkung in der Bohrung 21 und die Kohäsion der Schmelze nicht ausreichen würden. Über die verengte Mündung 62 wird weiter unten anhand der Fig. 7 noch weiteres ausgeführt.

Beim Vorschub des festen Lots 1 wirkt dieses in der Bohrung 21 gewissermassen als Kolben auf das flüssige Lot 1'. Der vorgeschobene, feste Abschnitt wird unmittelbar wieder bis zur Höhe des lagestabilen Temperaturübergangs aufgeschmolzen. Die Heizleistung richtet sich im wesentlichen nach der beim Betrieb pro Zeiteinheit auszutragenden Lotmenge. Am Ende des festen Drahtabschnittes stellt sich beim Ausstossvorgang selbsttätig eine gewisse Dichtwirkung ein, indem etwa in den Führungsspalt zwischen Draht und Bohrungswand eindringende Schmelze sogleich erstarrt und am Draht mitgeschoben wird. Als Folge dieser Dichtwirkung im Bereich des grossen Temperaturgradienten zwischen den Zonen x und y können auf das flüssige Lot 1' erhebliche Pumpdrücke ausgeübt werden.

Die Antriebsmittel 3 zum schrittweisen Vorschub des draht- oder stangenförmigen Lots 1 weisen gemäss Fig. 1 eine Antriebsrolle 31 und eine Tastrolle 32 auf, zwischen denen das Lot hindurchgeführt wird. Mit der Antriebsrolle 31 ist ein Motor 30, zweckmässigerweise ein Schrittmotor, verbunden, der ein Vorschubsignal von einem Regler 34 erhält. Das Vorschubsignal wird im Regler abgeleitet einerseits von einem Eingangssignal 35, das der jeweils auszustossenden Lotmenge als Sollwert entspricht, und anderseits einem Wegmesssignal als Istwert des Vorschubweges, erzeugt von einem Drehgeber (Encoder) 33, der mit der Tastrolle 32 verbunden ist. Da ein konstanter Querschnitt des verwendeten festen Lots vorausgesetzt werden kann, entspricht ein bestimmter Vorschubweg des Lotdrahtes 1 genau einem bestimmten Volumen der durch die Austrittsmündung 22 ausgestossenen, flüssigen Lotportion.

Wie weiter oben erwähnt, werden mit der dargestellten Einrichtung die Lotportionen über einen an das Führungsrohr 20 anschliessenden Formstempel 6 auf das Substrat 4 übertragen. Das Rohr 20 und der Tiegel 26 einerseits und der Körper 60 des Formstempels 6 andererseits berühren einander entlang einer Kugelfläche 24, in der die Mündung 22 enthalten ist. Der Formstempel 6 wird mittels kardanischer Lagerung, wie sie insbesondere aus Fig. 2 ersichtlich ist, in Berührung mit der Kugelfläche 24 gehalten. Ein Kardanring 40 ist auf einem Ringdurchmesser an zwei Stangen 42 schwenkbar gehalten, die sich nach oben in das Gehäuse 10 erstrecken und in einem Tragring 44 festsitzen; der Tragring 44 liegt am Gehäuse lose auf. Auf einem zu den Stangen 42 um 90° versetzten Durchmesser des Kardanringes 40 befinden sich zwei nach innen ragende Lagerstifte 45. Auf diesen liegt ein oben am Körper 60 des Formstempels 6 angebrachter Kragen 64 mit entsprechenden Halbrund-Einschnitten 65 auf (siehe auch Fig. 4 und 5). Dank dieser Lagerung ist der Formstempel 6 über der Kugelfläche 24 allseitig schwenkbar, um sich beim Absenken auf das Substrat 4 an dessen Oberseite genau anzuschmiegen. Eine vorgespannte Druckfeder 29 über der Hülse 27 erzeugt einen stetigen Kontaktdruck an der Kugelfläche 24, wodurch der Formstempel 6 jeweils nach dem Abheben seine Lage beibehält und eine gute Dichtwirkung gegen den Austritt von Lot am Übergang vom Rohr 20 in die Bohrung 62 des Formstempels 6 erzielt wird.

Es können auch verschiedene Formstempel leicht gegeneinander ausgetauscht werden. Der jeweils eingesetzte Formstempel wird zu diesem Zweck angehoben, wobei über den Tiegel 26 und die Hülse 27 die Druckfeder 29 zusammengedrückt wird. Durch Drehen des angehobenen Formstempels um 90° wird dann der Kragen 64 über die Lagerstifte 45 hinweggedreht, bis die Rillen 65 etwa mit den Stangen 42 fluchten und der Formstempel nach unten herausgenommen werden kann. Auf analoge Weise wird ein neuer Formstempel eingesetzt, wobei die Konstruktion eine hohe Lagegenauigkeit desselben sicherstellt, so dass nach dem Austausch des Formstempels kein Justieren notwendig ist. Ausser dem Formstempel 6 sind der Tiegel 26 zusammen mit dem Rohr 20 die einzigen Teile der Einrichtung, die mit flüssigem Lot in Kontakt treten und deshalb einer gewissen Verschmutzung ausgesetzt sein können. Die dargestellte Konstruktion erlaubt jedoch vorteilhafterweise ein einfaches, rasches und reproduzierbares Auswechseln auch des Tiegels 26 mit dem Rohr 20.

Vom Tiegel 26 aus wird der Formstempel 6 über die Kugelfläche 24 ebenfalls auf die Arbeitstemperatur T_{H}, des Lots beheizt. Der Formstempel 6 - wie auch der Tiegel 26 und das Führungsrohr 20 sind aus einem Material gefertigt, das vom geschmolzenen Lot 1' nicht benetzbar ist. Geeignete Werkstoffe sind z.B. Graphit, Keramik, Glas oder auch rostfreier Stahl und Titan.

Aus den Fig. 3, 4 und 5 sind weitere vorteilhafte Gestaltungsmerkmale des Formstempels 6, insbesondere bezüglich seines Formhohlraumes 61, ersichtlich. Der Formhohlraum 61 des Formstempels 6 befindet sich an der Unterseite des Körpers 60, wird durch einen Auflagerand 66 begrenzt und ist nach unten gegen das Substrat hin offen. Über einen von der Kugelfläche 24 ausgehenden, relativ engen Eingusskanal 62 kommuniziert der Formhohlraum 61 mit der Austrittsmündung 22 am Führungsrohr 20. Im Körper 60 des Formstempels 6 sind Steigerkanäle 63 vorhanden, die vom Hohlraum 61 ausgehen und nach oben offen sind. Vorzugsweise befinden sich solche Steigerkanäle, wie dargestellt, in den Ecken bzw. in Randbereichen des Formhohlraumes, um die vollständige und rasche Formfüllung zu gewährleisten; selbstverständlich wird die Anordnung von Steigerkanälen entsprechend der jeweiligen Geometrie des Formhohlraums gewählt. Die Flächenausdehnung des Formhohlraums wiederum richtet sich nach derjenigen der aufzulötenden Chips. Die aufgetragenen, schmelzflüssigen Lotportionen werden (wie an sich bekannt) beim anschliessenden Aufbringen des Chips von diesem im Lotspalt "gequetscht" bis zur vollflächigen Benetzung des Chips und des Substrats.

Bei Betriebsbereitschaft der dargestellten Einrichtung steht im unteren Bereich x des Führungsrohres 20 ein bestimmter Vorrat an flüssigem Lot 1' bereit. Infolge Kapillarwirkung in der Bohrung 21 und insbesondere im verengten Kanal 62 fliesst dieses nicht von selbst aus. Die Einrichtung wird nun abgesenkt (Pfeil a) bis zum Aufsitzen des Formstempels 6 auf dem Substrat 4. Dieses Absenken erfolgt mit einem kleinen Überhub, so dass die Feder 29 etwas zusammengedrückt und der Ring 44 abgehoben wird. Die Feder 29 dämpft auch den Schlag des auf das Substrat auftreffenden Formstempels 6. Dabei passt sich der kardanisch gelagerte Formstempel 6 unter der Federwirkung einer allfälligen, geringen Schieflage des Substrats 4 genau an und der Auflagerand 66 schliesst den Formhohlraum 61 dicht ab. Durch den Überhub werden auch gewisse Toleranzen in der Höhenlage des Substrats und in der Fertigungshöhe der Formstempel überbrückt.

Spätestens nach dem Aufsetzen des Formstempels 6 wird der Vorschub des festen Lotes 1 durch ein Startsignal 35 (Sollwert des Vorschubweges) ausgelöst und damit eine entsprechende, abgemessene Portion des flüssigen Lots durch die Mündung 22 in den Formhohlraum 61 ausgestossen, wobei die vorhandene Luft über die Kanäle 63 entweicht. Nachdem der Hohlraum 61 gefüllt ist, steigt flüssiges Lot auch in die Kanäle 63 auf, wie in Fig. 6 dargestellt ist.

Zusätzliche Vorteile können dadurch erzielt werden, dass man den Lot-Ausstoss (Beginn des Startsignals 35) bereits etwas vor dem Auftreffen des Formstempels 6 auf dem Substrat 4 beginnen lässt: Einerseits kann so die Taktzeit insgesamt verkürzt werden, indem sich die Zeitabschnitte für das Absenken und für den Lot-Ausstoss teilweise überlappen. Vor allem aber kann der bereits ausgestossene Lottropfen - bei noch bestehendem Abstand des Formstempels 6 über dem Substrat - sich bereits seitlich über einen erheblichen Teil der Formfläche ausbreiten und das Substrat benetzen, unbehindert durch die im allgemeinen sehr geringe Höhe des Formhohlraums 61 (die Tiefe der Ausnehmung 61 im Körper 60 ist zumeist wesentlich geringer, als in den Fig. 1, 4 und 6 zwecks deutlicherer Darstellung gezeichnet). Das seitliche Ausbreiten des flüssigen Lots bis zu den Rändern des Formhohlraumes setzt sich fort, während der Formstempel 6 vollends auf das Substrat aufgesetzt wird.

Eine Wirkung der Steigerkanäle 63 - Sicherstellung der vollständigen Formfüllung - wurde weiter oben bereits erwähnt. Es ist vorteilhaft, das durch die Kanäle 63 gebildete (im Vergleich mit dem Volumen des Formhohlraums 61 erhebliche) Speichervolumen gezielt auszunutzen, indem man die Höhe des Raumes 61 etwas geringer wählt als zur Erzeugung der verlangten Lot-Schichtdicke (nach Montage des Chips) erforderlich wäre. Ein beträchtlicher Teil der benötigten Lotportion gelangt dann (bei aufsitzendem Formstempel, Fig. 6) zwangsläufig in die Steigerkanäle 63, wobei mit sehr grosser Sicherheit, selbst bei gewissen Variationen des ausgestossenen Volumens, auch die Ecken und Ränder der Formfläche benetzt werden. Beim anschliessenden Abheben des Formstempels 6 fliesst die in den Kanälen 63 gespeicherte Lotmenge sogleich zurück und verteilt sich über der benetzten Fläche. Schliesslich kann auch der Lotvorschub bzw. die Portionengrösse im Rahmen des Speichervolumens der Steigerkanäle 63 variiert werden, um mit einem und demselben Formstempel 6 entsprechend unterschiedliche End-Schichtdicken im Lotspalt zu erzielen.

Nach beendetem Lotvorschub und Ausstossen der Lotportion wird sogleich die Einrichtung 5 vom Substrat abgehoben. Das flüssige Lot bleibt auf dem Substrat haften und reisst im Kanal 62 unter der Mündung 22 ab; das in den Kanälen 63 vorhandene Flüssiglot verteilt sich, wie erwähnt, über der vom Lot benetzten Fläche. Das beheizte Substrat 4 wird dann in bekannter Weise einen Schritt vorgeschoben (Pfeil c), so dass ein neues Substratfeld unter die Einrichtung gelangt und ein Chip 8 auf die eben aufgetragene, noch flüssige Lotportion 1" plaziert werden kann. Es kann nun ein neuer Arbeitszyklus beginnen.

Grundsätzlich ist es auch möglich, mit einem einzigen Formstempel zwei oder mehrere voneinander getrennte Lotportionen nebeneinander im gleichen Takt auf dieselbe Substratfläche auszutragen, jede Portion mit definierter Flächenausdehnung und in genauer Position. Hierfür wird ein Formstempel mit den den benötigten Lotportionen entsprechenden, separaten Formhohlräumen verwendet (nicht dargestellt). Jeder dieser Formhohlräume wird über einen eigenen, von der Mündung 22 ausgehenden Kanal gespeist. Eine Aufteilung der im selben Takt ausgestossenen Gesamt-Lotmenge in Teilportionen entsprechend unterschiedlichen Volumina der einzelnen Formhohlräume kann durch Anpassen der Strömungswiderstände (Durchmesser und Länge) der erwähnten Kanäle erreicht werden.

Es wurde bereits erwähnt, dass die ausgetragene Lotportion jeweils innerhalb der Bohrung 62 abreisst. Die Trennstelle innerhalb der Länge der Bohrung ist dabei unbestimmt, was eine gewisse Streuung in der Grösse der aufeinanderfolgenden Portionen bedeutet. Zwecks genauerer Dosierung kann diese Streuung vermindert werden, indem die Bohrung 62 verkürzt wird, insbesondere nach Fig. 7, wonach die Bohrung bei 62a von oben her aufgeweitet ist. Dadurch ist sichergestellt, dass die Schmelze nur im kurzen Bohrungsstück 62 abreissen kann.

## Patentansprüche

1. Formstempel (6) zum Austragen von flüssigem Lot (1'), der einen mit einem Eingusskanal (62) verbundenen, nach unten offenen Formhohlraum (61) aufweist, **dadurch gekennzeichnet, dass** der Formstempel (6) aus einem vom geschmolzenen Lot nicht benetzbaren Material besteht und dass der Eingusskanal (62) auf der dem Formhohlraum (61) abgewandten Seite mit einem abrupten Übergang aufgeweitet ist.

2. Formstempel (6) nach Anspruch 1, **dadurch gekennzeichnet, dass** der Formstempel (6) vom Formhohlraum (61) ausgehende Steigerkanäle (63) zur Aufnahme von flüssigem Lot (1') aufweist, deren Speichervolumen einen Teil des auszutragenden Lotes aufzunehmen vermag.

3. Formstempel (6) nach Anspruch 1 oder 2, **gekennzeichnet durch** mehrere separate Formhohlräume.

4. Formstempel (6) nach einem der Ansprüche 1 bis 3, **dadurch gekennzeichnet, dass** der Eingusskanal (62) auf der dem Formhohlraum (61) zugewandten Seite so eng ist, dass das geschmolzene Lot infolge Kapillarwirkung nicht von selbst ausfliesst.

## Claims

1. Molding die (6) for dispensing liquid solder (1'), having a molding cavity (61) communicating with an inlet (62) and open to the bottom, **characterized in that** the molding die (6) consists of a material non-wettable by the molten solder and that the inlet (62, 62a) is widened on the side opposite the cavity (61) by an abrupt transition.

2. Molding die (6) in accordance with claim 1, **characterized in that** the molding die (6) has vent holes (63) for receiving molten solder (1') which rise from the molding cavity (61), the storage volume of which can receive a part of the solder to be dispensed.

3. Molding die (6) in accordance with claim 1 or 2, **characterized by** several separate molding cavities.

4. Molding die (6) in accordance with one of claims 1 to 3, **characterized in that** the inlet (62) on the side facing the cavity (61) is so narrow that because of capillary action the molten solder does not run out by itself.

## Revendications

1. Moule de formage (6) pour l'applicage de soudure liquide (1'), comportant une cavité creuse profilée (61) connectée avec un conduit de remplissage (62) et ouverte vers le bas, **caractérisé en ce que** le moule de formage (6) se compose d'un matériau ne pouvant pas reçevoir de dépôt de soudure en fusion et que le conduit de remplissage (62) est élargie à la façe détournée de la cavité creuse profilée (61) par une transition abrupte.

2. Moule de formage (6) selon la revendication 1, **caractérisé en ce que** le moule de formage (6) est muni de conduits de remontée (63) pour la réception de soudure en fusion (1'), qui partent de la cavité creuse profilée (61) et dont le volume de stockage peut absorber une partie de la soudure à mettre en applicage.

3. Moule de formage (6) selon la revendication 1 ou 2, **caractérisé par** plusieurs cavités creuse profilées séparées.

4. Moule de formage (6) selon une des revendications 1 à 3, **caractérisé en ce que** le conduit de remplissage (62) est si étroit à la façe tournant vers la cavité creuse profilée (61) qu'à cause de l'effet de capillarité la soudure en fusion ne s'écoule pas d'elle-même.
